# EUROPEAN PATENT APPLICATION

(11) **EP 2 439 769 A1**
(43) Date of publication of application: **11.04.2012**
(21) Application number: 11184377.7
(22) Date of filing: 07.10.2011
(51) Int. Cl.: H01L 21/67, H01L 21/677, A21B 1/48, A21B 2/00, C30B 25/12, C30B 25/14, F26B 3/30, F26B 15/16, F27B 9/10, F27B 9/36, F27D 99/00

(54) **Apparatus with multiple heating systems for in-line thermal treatment of substrates**

(30) Priority: 07.10.2010 US 390973 P
(71) Applicant: Sandvik Thermal Process, Inc., Sonora, CA 95370 (US)
(72) Inventor: Helms, Jr., Aubrey L, Sonora, CA California 95032 (US); Peck, Kevin B., SONORA, CA California 95370 (US); Johnson, James T, Sonora, CA California 95370 (US); Nilsson, Pontus K.H, Oakdale, CA California 95361 (US); Reynolds, Reese, Los Gatos, CA California 95032 (US)
(74) Representative: Melin Granberg, Linda

(57) **Abstract**

The present invention relates to in-line equipment used to process substrates. In some applications, the equipment is used in the in-line manufacture PV cells or modules. In some embodiments, a heating system is provided that comprises a plurality of heating technologies for the heat treatment of substrates wherein a first heating system is used to rapidly raise the substrate temperature to the desired set point and a second heating system is used to maintain the substrate at the temperature set point throughout the thermal treatment process.

## Description

### FIELD OF INVENTION

The present invention relates generally to the field of in-line equipment used to thermally treat substrates. More specifically, the present invention relates to in-line equipment used in the manufacture of photovoltaic (PV) solar cells or thin film (TF) modules.

### BACKGROUND OF THE INVENTION

In-line equipment is used in many industries to thermally treat substrates. That is, the substrates move through the equipment in a continuous manner or in small steps. The input portion of the equipment is positioned at one end of the system and the output portion is positioned at the opposite end. Exemplary technologies may include, but are not limited to, semiconductors, microelectromechanical systems (MEMS), printed circuit board (PCB) manufacturing, low temperature co-fired ceramics (LTCC), high temperature co-fired ceramics (HTCC), metal annealing, soldering, and photonics, among others.

Solar energy is widely accepted as being an excellent source of renewable energy. Photovoltaic (PV) cells which can convert sunlight into electricity have been studied for the past ~70 years. The adoption and wide spread use of PV cells has been slow because they have exhibited poor conversion efficiency and have been expensive to manufacture. Therefore, the economics ($/Watt) of using PV cells to generate electricity have not been competitive with traditional sources such as coal, oil, natural gas, etc. The $/Watt metric represents the total system cost to generate a Watt of energy. Lower PV solar cell efficiencies and higher PV solar cell system costs increase this metric and lowers the competitiveness of the PV solar cell system relative to traditional energy generation systems.

Recent advances in the design and manufacture have improved the efficiency of the PV solar cells and lowered the manufacturing cost such that PV based solar energy systems have improved economics. It is a goal that PV based solar energy systems will be able to generate electricity at costs that are competitive with traditional electricity generation methods in the near future. For this goal to be realized, advances must be made to continue to improve the conversion efficiency of the PV solar cells and to lower the manufacturing costs.

In the manufacture of PV solar cells or thin film (TF) modules, substrates are often processed in equipment configured in an "in-line" structure. That is, the substrates move through the equipment in a continuous manner or in small steps. The input portion of the equipment is positioned at one end of the system and the output portion is positioned at the opposite end. This type of equipment is to be distinguished from "batch" systems wherein the substrates are generally processed in large batches and the input and output portions of the equipment are generally found at the same end of the system. In the in-line equipment, an automation system is used to translate the substrates from the input end to the output end. The automation system may comprise a conveyor, a belt, discrete pallets, rollers, a "walking beam" system, chains, strings, or cables, among others.

Current in-line equipment for the manufacture of PV based solar cells or TF modules suffer from a number of problems. Examples of these problems may be slow temperature response, slow substrate temperature ramp rate, high equipment cost, low throughput, large footprint, poor performance, contamination of the substrate by the automation system, shadowing of the backside of the substrate by the automation system, movement of the substrate during processing, slow heating rate, poor doping uniformity, and others. These problems may act individually or in combination to lower the efficiency of the PV solar cells or TF modules or increase the cost of manufacturing the PV solar cells or TF modules. This will increase the $/Watt economic metric used to evaluate energy system performance and slow the adoption of PV solar energy systems. Therefore, there is a need for heating systems to be used in in-line equipment used to manufacture PV solar cells or TF modules that address these problems.

### SUMMARY OF THE INVENTION

Accordingly and advantageously the present invention provides heating systems that comprise multiple heating technologies applied to in-line diffusion processes in the thermal treatment of substrates in an in-line system. In some embodiments of the present invention, multiple heating systems are incorporated into in-line equipment used in the manufacture of PV cells or TF modules. In some embodiments of the present invention, a first heating system is provided that rapidly raises the temperature of the substrate to the desired temperature. Typical heating rates may fall in the range of 10 to 100 C/sec. Exemplary heating technologies for the first heating system comprise lamp-based heating systems, strip heaters, high surface energy radiating heaters (i.e. MoSi₂ heaters), electromagnetic radiation heating systems (i.e. microwave or radio frequency heating systems), and combinations thereof. A second heating system is also provided that maintains the substrate at the desired temperature. Exemplary heating technologies for the second heating system comprise resistive heating systems, strip heaters, high surface energy radiating heaters (i.e. MoSi₂ heaters), electromagnetic radiation heating systems (i.e. microwave or radio frequency heating systems), and combinations thereof.

Additionally, in some embodiments of the current invention, the multiple heating technology systems may be applied to technologies outside the solar energy industry that also use in-line heating systems for the thermal treatment of substrates. Exemplary technologies may include, but are not limited to, semiconductors, microelectromechanical systems (MEMS), printed circuit board (PCB) manufacturing, low temperature co-fired ceramics (LTCC), high temperature co-fired ceramics (HTCC), metal annealing, soldering, and photonics, among others.

These and other advantages are achieved in accordance with the present invention as described in detail below.

### BRIEF DESCRIPTION OF THE DRAWINGS

To facilitate understanding, identical reference numerals have been used, where possible, to designate identical elements that are common to the figures. The drawings are not to scale and the relative dimensions of various elements in the drawings are depicted schematically and not to scale.

The techniques of the present invention can readily be understood by considering the following detailed description in conjunction with the accompanying drawings, in which:

FIG. 1 illustrates a temperature versus time curve for a heating apparatus using resistive heaters.

FIG. 2 illustrates a temperature versus time curve for a heating apparatus using lamp based heaters.

FIG. 3 illustrates a block diagram of one embodiment of the present invention.

### DETAILED DESCRIPTION OF THE INVENTION

After considering the following description, those skilled in the art will clearly realize that the teachings of the invention can be readily utilized in the diffusion and/or annealing of substrates used for photovoltaic devices, semiconductor devices, and the like

One process step in the manufacture of a PV cell or TF module typically includes a diffusion step wherein a dopant is diffused into the substrate to form an emitter layer or a contact junction. A common step comprises the diffusion of phosphorous into a silicon material. The diffusion step has historically been accomplished in a batch furnace wherein a plurality of substrates may be processed simultaneously. The diffusion step may require process temperatures up to about 950C and may require process times up to about 20 minutes or more. The relationship between phosphorous concentration, temperature, and time and their affect on the resistivity of the diffused layer in silicon are well known in the art.

Many of the other process steps in the manufacture of a PV cell or TF module are in-line processes wherein a single substrate is processed individually and the material proceeds through the system in a continuous manner. The basics of this technology are well known and have been used for years in fields such as semiconductors, printed circuit board (PCB) manufacturing, low temperature co-fired ceramics (LTCC), high temperature co-fired ceramics (HTCC), metal annealing, and soldering. Alternatively, a small number of substrates (typically less than about 50) may be loaded onto pallets or substrate carriers and processed within a system that conveys the pallets through the system in a continuous manner. Examples of this type of system comprise "in-line" plasma enhanced chemical vapor deposition (PECVD) and physical vapor deposition (PVD) systems used to deposit thin films on the substrates under vacuum.

In-line processing may have advantages over batch processing due to less breakage due to reduced handling of the substrates, higher throughputs, simple system architecture, and balanced material flow through the manufacturing line, among others. The development of an in-line system and technology for the diffusion process has been an area of active research.

The in-line diffusion (ILD) process typically comprises two steps. In the first step, a dopant source is applied to the substrate. Typical dopant atoms may include phosphorous, arsenic, antimony, bismuth, boron, aluminum, gallium, and indium. Those skilled in the art will realize that this list is not exhaustive and other dopants may be used depending on the application and the substrate material. The dopant atoms are often carried in a liquid or paste. The liquid or paste containing the dopant atoms may be applied using many different technologies. Examples of application technologies comprise spray-on, roll-on, aerosol, "fog", screen printing, ink-jet printing, and immersion, among others. Those skilled in the art will realize that this list is not exhaustive and other technologies may also be used.

In the second step, the substrate is conveyed to a furnace process chamber wherein the substrate is heated to a desired temperature and held at that temperature for a defined time period. The concentration of dopant atoms applied to the substrate, the temperature set point, and the time the substrate is held at the temperature set point will determine the final resistivity of the diffused layer. The substrates are typically conveyed on a continuously moving conveyance system. Typical conveyance systems comprise belts, rollers, "walking beams", and strings, among others. Therefore, the heating time and the speed of the conveyance system determines the overall length of the furnace process chamber. The substrates exit through a cooling section wherein their temperature is reduced to less than about 70C so that they may be handled and prepared for the next process step.

Typically, the furnace process chamber process chamber has utilized a resistive heater technology to heat the substrates. In this technology, a high current is passed through high resistive wire causing it to rise in temperature and emit thermal radiation to increase the temperature of the substrates. This technology is well known. The temperature stability and uniformity of these systems are quite good with temperature uniformity specifications of ±2C being easily achieved. However, the temperature response of these systems may be slow and the ramp rate of temperature of the substrate from room temperature to the desired diffusion temperature is slow. Substrate temperature ramp rates may be up to a maximum of about 500C per minute. Typical values are lower, less than 200C per minute.

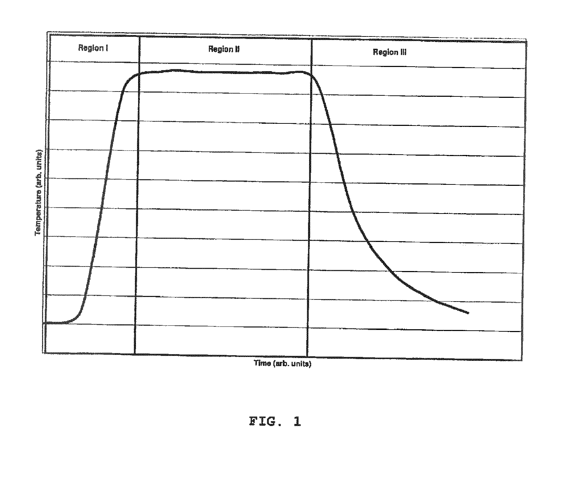

An example of a substrate temperature versus time plot for a substrate heated using resistive heating technology is illustrated in **FIG. 1****. Region I** illustrates the increase in the temperature of the substrate from room temperature to the desired set point. The time for **Region I** is typically between 1 and 4 minutes or more. Region II illustrates the period of time during which the substrate temperature is maintained at the desired diffusion temperature. The time for **Region II** may be up to about 20 minutes or even longer depending on the desired resistivity of the diffused layer. **Region III** illustrates the cooling of the substrate temperature from the set point to a temperature low enough to handle and prepare for the next process step.

An alternative heating technology for ILD systems comprises the use of infrared lamps (IR) as the heating source. The lamps may be chosen so that they emit radiation at a wavelength that the substrate absorbs very strongly. The response of the lamps may be very fast. This allows typical substrate temperature ramp rates of up to about 900C per minute. However, the lamps have a limited lifetime (typically 5,000 - 8,000 hours) and are quite expensive. An ILD system may require up to about 100 lamps. Each lamp will need to be replaced at least once per year. This increases the cost of ownership of the system and decreases the total productive time for the system due to the maintenance time required to replace all of the lamps.

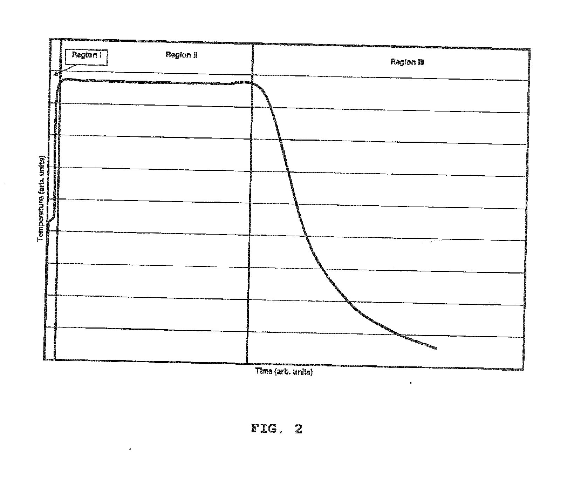

An example of a substrate temperature versus time plot for a substrate heated using lamp heating technology is illustrated in **FIG. 2****. Region I** illustrates the increase in the temperature of the substrate from room temperature to the desired set point. The time for **Region I** is typically less than 1 minute. **Region II** illustrates the period of time during which the substrate temperature is maintained at the desired diffusion temperature. The time for **Region II** may be up to about 20 minutes or even longer depending on the desired resistivity of the diffused layer. **Region III** illustrates the cooling of the substrate temperature from the set point to a temperature low enough to handle and prepare for the next process step.

During the slow increase in the temperature of the substrate when using the resistive heating technology, the liquid or paste used to deliver the dopant atoms may dry, evaporate, sublime, or react with the substrate in a non-uniform manner. This will lead to a non-uniform diffusion and result in a non-uniform emitter or contact junction layer in the device as evidenced by non-uniformity in the resistivity of the diffused layer.

The use of the lamp based heating technology decreases the non-uniformity due to the slow temperature ramp rate discussed above by increasing the substrate temperature to the desired set point in less than one minute. In the case of lamps, the liquid or paste used to deliver the dopant atoms may dry, evaporate, sublime, or react with the substrate in a more uniform manner due to the short time. However, as mentioned previously, the cost of ownership of the lamp based systems is very high because all of the lamps must be replaced at least once per year.

In some embodiments of the present invention, heating systems that comprise multiple heating technologies applied to in-line thermal treatment equipment are provided. In some embodiments of the present invention, a first heating system is provided that rapidly raises the temperature of the substrate to the desired temperature. Typical heating rates may fall in the range of 10 to 100 C/sec. Exemplary heating technologies for the first heating system comprise lamp-based heating systems, strip heaters, high surface energy radiating heaters (i.e. MoSi₂ heaters), microwave heating systems, and combinations thereof. A second heating system is also provided that maintains the substrate at the desired temperature The second heating system is designed to maintain the substrate at the desired set point in a cost effective manner with minimal service required. Exemplary heating technologies for the second heating system comprise resistive heating technologies, strip heaters, high surface energy radiating heaters (i.e. MoSi₂ heaters), microwave heating systems, and combinations thereof..

### Example 1

In some embodiments of the present invention, the first heating system comprises a small number of IR lamps. The lamps are typically positioned both above and below the conveyance system used to transport the substrates. The number of IR lamps typically ranges between 1 and 5 lamps positioned above the conveyance system and between 1 and 5 lamps positioned below the conveyance system. The second heating system comprises a resistive heating system to maintain the substrates at the desired set point. The second heating system may be long enough to maintain the substrates at the desired set point for the appropriate time at a given speed of the conveyance system. The speed of the conveyance system is determined by the desired production rate of the system.

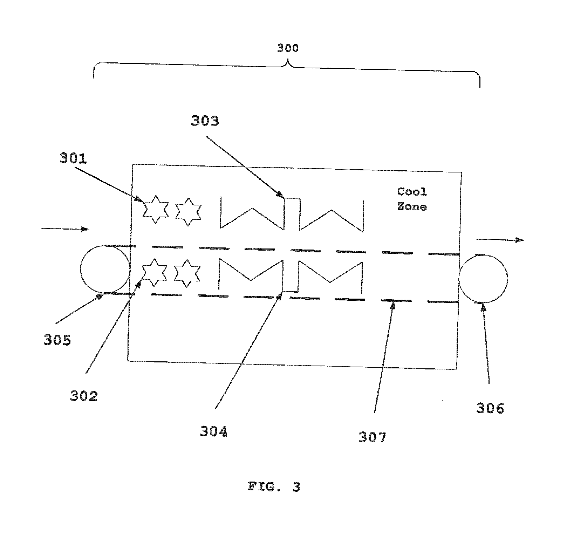

**FIG. 3** illustrates a block diagram of a system as described in Example 1. The overall system **300** is comprised of lamp heating systems **301** and **302** and resistive heating systems **303** and **304**. The substrates (not shown) are transported through the system on a conveyance system comprised of drums **305** and **306** and belt **307**. The substrate temperature versus time plot will be similar to that of FIG. 2 without the cost, downtime, and expense associated with systems utilizing only IR lamps.

Although various embodiments which incorporate the teachings of the present invention have been shown and described in detail herein, those skilled in the art can readily devise many other varied embodiments that still incorporate these teachings.

## Claims

1. A thermal treatment apparatus comprising:
a conveyance system adapted to move a material;
a first heating system disposed adjacent the conveyance system, the first heating system providing heat to raise a temperature of the material to a predetermined temperature; and
a second heating system disposed adjacent the conveyance system and downstream of the first heating system, the second heating system providing substantially stable and uniform heat to the material to maintain the temperature of the material at the predetermined temperature.

2. A thermal treatment apparatus according to claim 1, wherein the conveyance system comprises:
a plurality of drums; and
a belt disposed around the plurality of drums.

3. A thermal treatment apparatus according to claim 1, wherein the first heating system comprises an infrared lamp.

4. A thermal treatment apparatus according to claim 1, wherein the first heating system provides a heating rate in a range of approximately 10 to 100 C/sec.

5. A thermal treatment apparatus according to claim 1, wherein the second heating system comprises a resistive heater.

6. A thermal treatment apparatus according to claim 1, wherein the second heating system provides a temperature uniformity of about ± 2 C.

7. A thermal treatment apparatus according to claim 1, wherein the first heating system provides a larger material temperature ramp rate than the second heating system.

8. A thermal treatment apparatus according to claim 1, wherein the second heating system has a longer lifetime than the first heating system.

9. An in-line diffusion system comprising:
at least one substrate;
a dopant source that applies a dopant to the at least one substrate;
a conveyance that moves the at least one substrate with the applied dopant;
a first heater that is disposed adjacent to the conveyance and that provides a rise in a temperature of the at least one substrate to a predetermined temperature so as to minimize non-uniform diffusion of the applied dopant in the at least one substrate during the rise in the temperature of the at least one substrate; and
a second heater that is disposed adjacent to the conveyance and downstream of the first heater and that provides substantially stable and uniform heat to the at least one substrate to maintain the temperature of the at least one substrate at the predetermined temperature for diffusion of the applied dopant in the at least one substrate.

10. An in-line diffusion system according to claim 9, wherein the conveyance comprises:
a plurality of drums; and
a belt disposed around the plurality of drums.

11. An in-line diffusion system according to claim 9, wherein the first heater comprises an infrared lamp.

12. An in-line diffusion system according to claim 9, wherein the first heater provides a heating rate in a range of approximately 10 to 100 C/sec.

13. An in-line diffusion system according to claim 9, wherein the first heater is a plurality of first heaters.

14. An in-line diffusion system according to claim 9, wherein the second heater comprises a resistive heater.

15. An in-line diffusion system according to claim 9, wherein the second heater provides a temperature uniformity of about ± 2 C.

16. An in-line diffusion system according to claim 9, wherein the second heater comprises a plurality of second heaters.

17. An in-line diffusion system according to claim 9, wherein the first heater provides a larger substrate temperature ramp rate than the second heater.

18. An in-line diffusion system according to claim 9, wherein the second heater has a longer lifetime than the first heater.

19. An in-line diffusion system comprising:
a conveyance that moves at least one substrate with an applied dopant;
a first heater that is disposed adjacent to the conveyance and that provides a rise in a temperature of the at least one substrate to a predetermined temperature so as to minimize non-uniform diffusion of the applied dopant in the at least one substrate during the rise in the temperature of the at least one substrate; and
a second heater that is disposed adjacent to the conveyance and downstream of the first heater and that provides substantially stable and uniform heat to the at least one substrate to maintain the temperature of the at least one substrate at the predetermined temperature for diffusion of the applied dopant in the at least one substrate.

20. An in-line diffusion system according to claim 19, wherein the first heater provides a larger substrate temperature ramp rate than the second heater.
